# EUROPÄISCHE PATENTSCHRIFT

(11) **EP 2 458 951 B1**
(45) Veröffentlichungstag und Bekanntmachung des Hinweises auf die Patenterteilung: **25.05.2016**
(21) Anmeldenummer: 11180698.0
(22) Anmeldetag: 09.09.2011
(51) Int. Cl.: H05K 5/00, H05K 3/30, H05K 3/34

(54) **Befestigtes elektronisches Getriebesteuerungsmodul**
Fixed electronic transmission control module
Module de commande d'engrenage électronique fixé

(30) Priorität: 25.11.2010 DE 102010061976
(43) Veröffentlichungstag der Anmeldung: 30.05.2012
(73) Patentinhaber: Robert Bosch GmbH, 70442 Stuttgart (DE)
(72) Erfinder: Zweigle, Peter, 71254 Ditzingen (DE); Zeleny, Franco, 74354 Besigheim (DE)

(56) Entgegenhaltungen:
- DE-A1- 4 439 471
- GB-A- 457 602
- US-A1- 2008 019 106

## Beschreibung

### Stand der Technik

Elektronische Steuermodule können beispielsweise für Fahrzeuggetriebe verwendet werden. Ein Steuermodul umfasst dabei elektronische Schaltungen, die von einem Schutzgehäuse umgeben sind. Die Anschlüsse dieser Schaltungen werden durch Löten mit einer Platine verbunden. Die Lötstellen sind unterschiedlichen Belastungen und Umwelteinflüssen ausgesetzt. Z.B. können an den Lötstellen mechanische Belastungen, wie z.B. Trägheitskräfte bei Beschleunigung des Fahrzeugs, auftreten. Ferner kann z.B. Getriebeöl mit Bearbeitungsspänen an die Lötstellen gelangen und dort einen Kurzschluss verursachen.

### Offenbarung der Erfindung

Es kann daher ein Bedarf an einem verbesserten elektronischen Steuermodul und einem entsprechenden verbesserten Verfahren zur Herstellung des elektronischen Steuermoduls bestehen, die insbesondere eine Entlastung von Lötstellen und einen Schutz gegen Kurzschlüsse gewährleisten.

Diese Aufgabe kann durch den Gegenstand der vorliegenden Erfindung gemäß den unabhängigen Ansprüchen gelöst werden. Vorteilhafte Ausführungsformen der vorliegenden Erfindung sind in den abhängigen Ansprüchen beschrieben.

Im Folgenden werden Merkmale, Einzelheiten und mögliche Vorteile einer Vorrichtung gemäß Ausführungsformen der Erfindung im Detail diskutiert.

Gemäß einem ersten Aspekt der Erfindung wird ein elektronisches Steuermodul zur Getriebesteuerung vorgestellt. Das Steuermodul weist ein Steuergerät zum Steuern des Getriebes, eine Leiterplatte und eine Trägerplatte auf. Die Leiterplatte ist dabei mit dem Steuergerät elektrisch leitend verbunden. Ferner ist die Leiterplatte mit dem Steuergerät mittels Hohlnieten zu einer ersten Einheit verbunden. Diese erste Einheit ist mit Hilfe von Befestigungselementen an der Trägerplatte befestigt. Die Befestigungselemente verlaufen dabei durch die Hohlräume in den Hohlnieten.

Anders ausgedrückt basiert die Idee der vorliegenden Erfindung auf einem Fixieren des Steuergeräts und der Leiterplatte in Bezug aufeinander mittels Hohlnieten beispielsweise vor dem Lötprozess und einer Nutzung der Hohlräume der Nieten zur Befestigung mit der Trägerplatte. Mittels der erfindungsgemäßen Vorrichtung können somit die Lötstellen zwischen Steuergerät und Leiterplatte von mechanischen Belastungen dank der zusätzlichen Befestigung mittels Hohlnieten geschützt werden. Durch Befestigen an der Trägerplatte und eventuell weiterer Schutz-Komponenten können die Lötstellen vor Umwelteinflüssen, wie beispielsweise Getriebeöl oder im Getriebeöl verkommenden Bearbeitungsspänen, geschützt und damit Kurzschlüsse vermieden werden. Weitere Vorteile der erfindungsgemäßen Vorrichtungen sind darin zu sehen, dass die Befestigung durch Hohlnieten und durch Befestigungselemente für einen kostengünstig herzustellenden und mechanisch stabilen Verbund zwischen Trägerplatte des Elektronikmoduls, der Leiterplatte und dem Steuergerät führt. Des Weiteren bewirkt die Nutzung der Hohlräume der Hohlnieten für die Befestigungselemente einen Sandwich- bzw. Stapelaufbau von Trägerplatte, Leiterplatte, Elektronikmodul und gegebenenfalls weiteren Elementen, die zum Beispiel konzentrisch angeordnet und platzsparend befestigt werden können.

Ferner kann die Verwendung von Hohlnieten zur Befestigung zwischen Steuergerät und Leiterplatte den Vorteil haben, dass eine Vormontage bzw. Fixierung beider Elemente in Bezug aufeinander vor dem Lötvorgang möglich ist. Des Weiteren kann durch den Hohlniet ein gewünschtes Abstandsmaß zwischen Steuergerät und Leiterplatte eingehalten werden, bei dem gleich die notwendigen Toleranzen bei der Montage berücksichtigt werden können. Dies kann Verzügen des Steuermoduls bei Temperaturänderungen vorbeugen.

Das Steuermodul kann zum Beispiel als Getriebesteuermodul ausgeführt sein, das beispielsweise zur Regelung, Steuerung und Kontrolle eines Kfz-Automatikgetriebes geeignet sein kann. Das Kfz-Automatikgetriebe kann beispielsweise ein stufenloses Getriebe (Continuously Variable Transmission; CVT), ein automatisches Stufengetriebe, ein Doppelkupplungsgetriebe oder ein automatisches Schaltgetriebe (ATM) sein.

Das Steuergerät, auch als Elektronikmodul bezeichnet, kann elektronische Schaltungen bzw. elektronische Bauelemente, wie zum Beispiel Halbleiter, Diodentransistoren, integrierte Schaltungen, Widerstände, Kondensatoren und Induktivitäten, aufweisen. Die elektronischen Schaltungen des Steuergeräts können im Getriebeinnenraum eingesetzt sein und durch ein Schutzgehäuse umgeben sein. Das Schutzgehäuse des Steuergeräts kann beispielsweise eine Kunststoffummoldung oder ein verschweißtes Stahlgehäuse sein. Bei einer Kunststoffummoldung können elektrische Anschlüsse seitlich aus der Moldmasse herausgeführt sein. Bei einem Stahlgehäuse können die elektrischen Anschlüsse, zum Beispiel ausgeführt als Anschlusspins, im Boden des Gehäuses eingelassen sein. Diese elektrischen Anschlüsse werden mit der Leiterplatte, auch als Platine bezeichnet, durch Löten elektrisch verbunden.

Bereits vor dem Löten oder alternativ nach dem Lötvorgang wird die Leiterplatte mit dem Steuergerät durch Hohlnieten zu einer ersten Einheit verbunden. Diese Verbindung ist beispielsweise vibrationsfest und kann den Lötvorgang durch die Fixierung beider Elemente in Bezug aufeinander erleichtern. Die Leiterplatte und das Steuergerät können zum Einführen der Hohlnieten entsprechende Ausnehmungen aufweisen. Es können beispielsweise mindestens zwei Hohlnieten zum Beispiel an diagonal gegenüberliegenden Ecken des Steuermoduls angeordnet werden. Ferner können zum Beispiel an jeder Ecke bzw. Kante des Steuergeräts Hohlnieten angeordnet sein. Die Hohlnieten können beispielsweise aus einem Metall oder Kunststoff gefertigt sein. Zum Beispiel können Hohlnieten aus Stahl, Kupfer, Messing, Aluminiumlegierungen oder Titan verwendet werden. Die Hohlnieten können plastisch verformbare zylindrische innen hohle Verbindungselemente darstellen. Die Verbindung zwischen Leiterplatte und Steuergerät mittels Hohlnieten kann beispielsweise mittels Kaltnietung oder Warmnietung eine formschlüssige und kraftschlüssige Verbindung beider Teile herstellen. Diese Verbindung kann z.B. irreversibel sein. Die Hohlnieten können beispielsweise als Drehteil in einem Drehverfahren oder als Rohrniete hergestellt werden. Ferner können die Hohlnieten ein- oder beidseitig einen Flach-, Rund- oder Senkkopf aufweisen.

Die erste Einheit, also die mit dem Steuergerät vernietete Leiterplatte, wird mittels Befestigungselementen, die beispielsweise als Schrauben ausgeführt sind, an der Trägerplatte befestigt. Dabei werden die Befestigungselemente durch die Hohlräume der Hohlnieten gesteckt bzw. durchgeführt. Dieser Aufbau ist kostengünstig und ermöglicht eine einfache platzsparende Montage.

Die Trägerplatte kann beispielsweise mit einer angeformten Kühlfläche für das Steuergerät versehen sein. Hierzu kann die Leiterplatte unter dem Steuergerät entsprechend ausgespart sein, so dass das Steuergerät mit der Kühlfläche in Kontakt treten kann. Alternativ kann die Trägerplatte flach ausgebildet sein, so dass das entsprechende Steuergerät einen tiefgezogenen Boden hat, um durch eine Aussparung in der Leiterplatte in Kontakt mit der Kühlfläche der Trägerplatte zu kommen. Ferner kann die Trägerplatte flach und die Leiterplatte durchgehend ausgestaltet sein, so dass das Steuergerät nicht gekühlt wird.

Gemäß einem Ausführungsbeispiel der Erfindung weist das elektronische Steuermodul ein Schutzelement auf. Das Schutzelement ist zumindest undurchlässig für Späne, wie zum Beispiel Bearbeitungsspäne, die im Getriebeöl vorkommen können, ausgeführt. Ferner kann das Schutzelement, auch als Spannschutzteil bezeichnet, eine luftdichte Abdichtung gewährleisten, so dass auch keine Flüssigkeiten an die Lötstellen gelangen können. Dies kann beispielsweise von Vorteil sein, wenn die Lötstellen gegen chemische Stoffe beispielsweise aus dem Getriebeöl geschützt werden sollen. Hierzu kann das Schutzelement beispielsweise aus einem Elastomermaterial ausgeführt sein.

Für den Fall, dass das Schutzelement für Flüssigkeiten durchlässig ausgestaltet ist, kann es als Schaumstoffteil ausgeführt sein. Dies hat insbesondere den Vorteil, dass lediglich geringe Montagekräfte auftreten, da beispielsweise ein Ölaustausch möglich ist und keine Druckkräfte auf den Verbund bei Temperaturschwankungen entstehen. Das Schutzelement ist zwischen der Trägerplatte und der ersten Einheit angeordnet und schützt das Steuergerät Trägerplatten-seitig. Das Schutzelement weist ferner entsprechende dritte Ausnehmungen auf, durch die die Befestigungselemente mit der Trägerplatte verbunden werden können.

Gemäß einem weiteren Ausführungsbeispiel der Erfindung weist das Steuermodul ferner ein Gehäuseelement, wie beispielsweise einen Deckel auf. Das Gehäuseelement ist auf einer der Trägerplatte gegenüberliegenden Seite der ersten Einheit angeordnet. Anders ausgedrückt kann der Sandwichaufbau des Steuermoduls wie folgt aussehen: Deckel, Steuergerät, Leiterplatte, Trägerplatte. Das Gehäuseelement weist ferner vierte Ausnehmungen auf und ist durch diese mittels der Befestigungselemente ebenfalls an der Trägerplatte befestigt. Hierzu fallen die vierten Ausnehmungen des Deckels mit den Hohlräumen der Hohlniete zusammen bzw. liegen über diesen. Die Anzahl der vierten Ausnehmungen im Gehäuseelement kann der Anzahl der Hohlnieten entsprechen. Alternativ können zum Beispiel bei vier Hohlnieten an allen vier Ecken des Steuergeräts lediglich zwei vierte Ausnehmungen an diagonal gegenüberliegenden Ecken am Gehäuseelement vorgesehen sein.

Gemäß einem weiteren Ausführungsbeispiel der Erfindung weist das Steuergerät erste Ausnehmungen und die Leiterplatte zweite Ausnehmungen auf. Das Steuergerät und die Leiterplatte können so angeordnet werden, dass die ersten Ausnehmungen über bzw. unter den zweiten Ausnehmungen liegen. Z.B. können die ersten und zweiten Ausnehmungen deckungsgleich sein. Die Anzahl der ersten Ausnehmungen entspricht der Anzahl der zweiten Ausnehmungen. Die Abmessungen der ersten Ausnehmungen und Abmessungen der zweiten Ausnehmungen können einer Außenabmessung, zum Beispiel einem Außendurchmesser, der Hohlniete entsprechen. Variiert der Außendurchmesser der Niete, so kann die Abmessung der ersten Ausnehmung sich von der Abmessung der zweiten Ausnehmung unterscheiden.

Gemäß einem weiteren Ausführungsbeispiel der Erfindung weist die Trägerplatte Aufnahmeelemente auf. Die Aufnahmeelemente greifen mit den Befestigungselementen ein. Die Aufnahmeelemente können beispielsweise Ausnehmungen mit einem Gewinde entsprechen, in die Befestigungselemente, zum Beispiel als Schrauben ausgeführt, eingeschraubt werden können. Alternativ können die Aufnahmeelemente und die Befestigungselemente als eine Clickand-Snap-Verbindung, das heißt eine Einschnapp- bzw. Einrastverbindung ausgeführt sein. Bei einer Ausgestaltung als Einschnappverbindung können die Befestigungselemente einstückig mit dem Gehäuseelement ausgeführt sein.

Gemäß einem weiteren Ausführungsbeispiel der Erfindung weisen die Hohlniete einen ersten Bereich mit einem ersten Durchmesser und einen zweiten Bereich mit einem zweiten Durchmesser auf. Dabei liegt der Durchmesser in einer Ebene senkrecht zur Längsrichtung bzw. Längsausdehnung der Hohlniete. Der erste Durchmesser ist dabei größer als der zweite Durchmesser.

Gemäß einem zweiten Aspekt der Erfindung wird ein Verfahren zur Herstellung eines elektronischen Steuermoduls vorgestellt. Das Verfahren weist die folgenden Schritte auf: Bereitstellen eines Steuergeräts, das mit ersten Ausnehmungen versehen ist und einer Leiterplatte, die mit zweiten Ausnehmungen versehen ist; Verbinden der Leiterplatte mit dem Steuergerät zu einer ersten Einheit mittels Hohlnieten, die in den ersten und zweiten Ausnehmungen angeordnet sind; Befestigen der ersten Einheit an einer Trägerplatte mittels Befestigungselementen, die in den Hohlräumen der Hohlniete angeordnet sind. Alternativ kann das Verfahren derart ausgestaltet sein, dass das Steuergerät und die Leiterplatte zunächst bereitgestellt werden und anschließend mit ersten und zweiten Ausnehmungen versehen werden.

Gemäß einem Ausführungsbeispiel der Erfindung weist das Verfahren ferner den folgenden Schritt auf: Anordnen eines Schutzelements zwischen der Trägerplatte und der ersten Einheit.

Gemäß einem weiteren Ausführungsbeispiel der Erfindung weist das Verfahren ferner den folgenden Schritt auf: Anordnen eines Gehäuseelements an einer der Trägerplatte gegenüberliegenden Seite der ersten Einheit.

Weitere Merkmale und Vorteile der vorliegenden Erfindung werden dem Fachmann aus der nachfolgenden Beschreibung beispielhafter Ausführungsformen, die jedoch nicht als die Erfindung beschränkend auszulegen sind, unter Bezugnahme auf die beigelegten Zeichnungen ersichtlich.
- Fig. 1: zeigt eine perspektivische Ansicht einer mittels Hohlnieten mit einem Steuergerät verbundenen Leiterplatte
- Fig. 2: zeigt einen Querschnitt durch einen Teil der in Fig. 1 dargestellten ersten Einheit
- Fig. 3: zeigt eine alternative Ausführungsform des Steuergeräts für das erfindungsgemäße elektronische Steuermodul
- Fig. 4: zeigt Querschnitte durch alternative Ausführungen von Hohlnieten des erfindungsgemäßen elektronischen Steuermoduls und die Befestigung der Hohlniete am Steuermodul
- Fig. 5: zeigt eine perspektivische Draufsicht auf eine Trägerplatte und ein Schutzelement des erfindungsgemäßen elektronischen Steuermoduls
- Fig. 6: zeigt eine perspektivische Draufsicht auf ein zusammengebautes elektronisches Steuermodul mit einem Gehäuseelement
- Fig. 7: zeigt einen perspektivischen Querschnitt entlang der Linie A-A in Fig. 6 durch ein erfindungsgemäßes elektronisches Steuermodul mit einem Gehäuseelement

Alle Figuren sind lediglich schematische Darstellungen erfindungsgemäßer Vorrichtungen bzw. ihrer Bestandteile gemäß Ausführungsbeispielen der Erfindung. Insbesondere Abstände und Größenrelationen sind in den Figuren nicht maßstabsgetreu wiedergegeben. In den verschiedenen Figuren sind sich entsprechende Elemente mit den gleichen Referenznummern versehen.

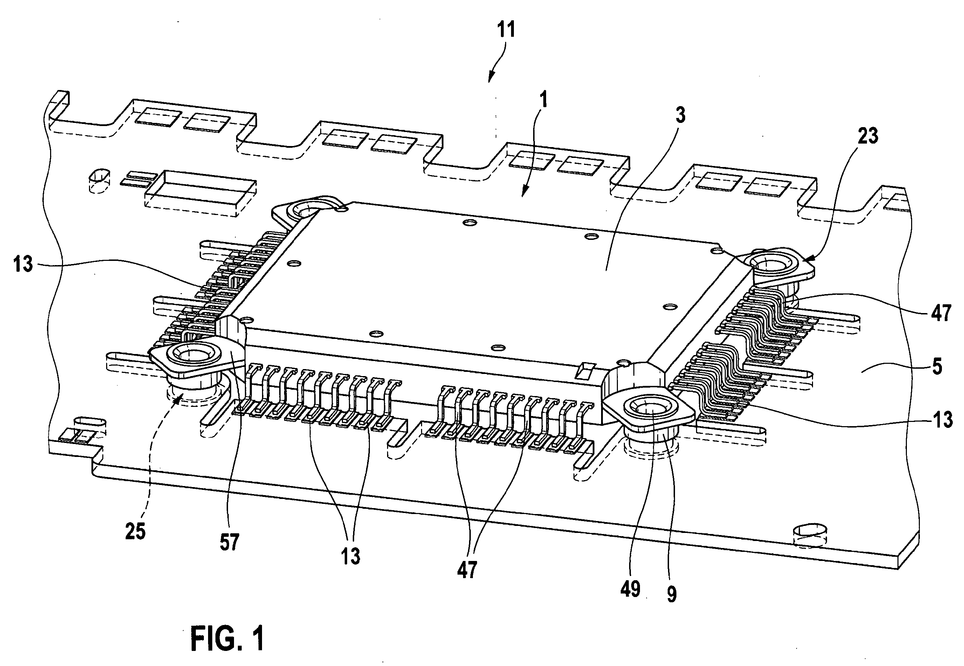

In Fig. 1 ist eine erste Einheit 11 eines elektronischen Steuermoduls 1 dargestellt. Die erste Einheit 11 weist ein Steuergerät 3 und eine Leiterplatte 5 auf. Die Leiterplatte 5 ist durch vier Hohlniete 9, die jeweils an den Ecken des Steuergeräts 3 angeordnet sind, mit dem Steuergerät 3 verbunden. Beispielsweise kann das Steuergerät 3 auf der Leiterplatte 5 in einem ersten Verfahrensschritt der Herstellung eines elektronischen Steuermoduls 1 positioniert und mittels Hohlnieten 9 befestigt und fixiert werden. Auf einer Seite des Hohlniets 9 kann die Leiterplatte 5 und auf der anderen Seite des Hohlniets 9 das Steuergerät 3 vernietet werden. Anschließend können die elektrischen Anschlüsse 47 des Steuergeräts 3 an entsprechenden Stellen der Leiterplatte 5 verlötet werden. Die so entstandenen Lötstellen 13 werden durch die weiter unten beschriebenen Komponenten des Steuermoduls 1 vor Umwelteinflüssen geschützt.

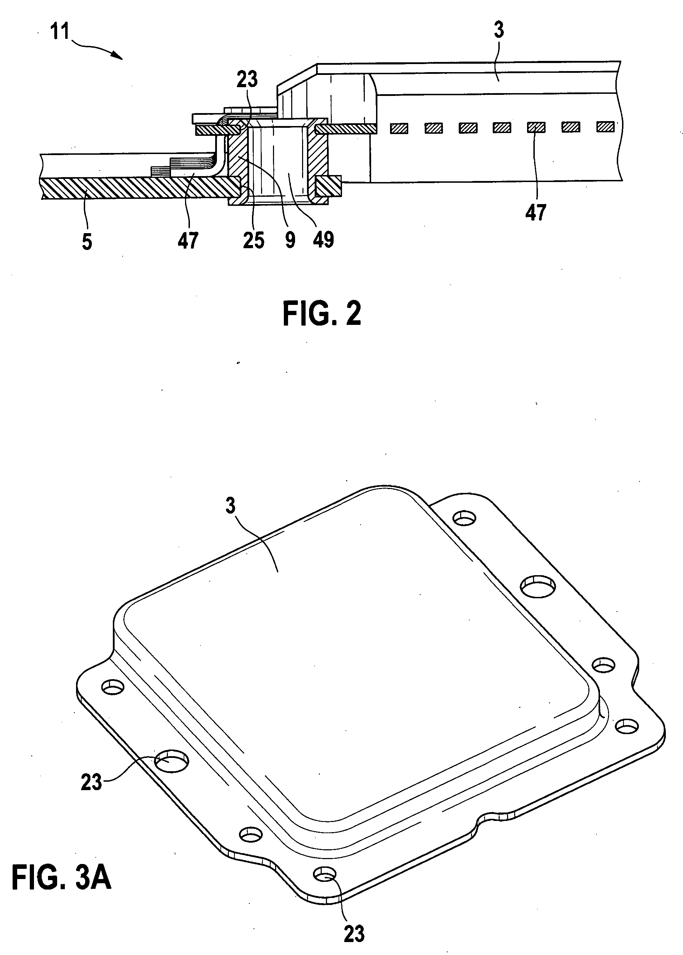

In Fig. 2 ist ein Teilquerschnitt der in Fig. 1 dargestellten ersten Einheit 11 gezeigt. Die Hohlniete 9 werden durch erste Ausnehmungen 23 im Steuergerät 3 und zweite Ausnehmungen 25 in der Leiterplatte 5 durchgeführt bzw. durchgesteckt und anschließend verformt. Die Hohlnieten 9 weisen Hohlräume 49 auf, durch die in späteren Verfahrensschritten Befestigungselemente 15 durchgeführt werden können.

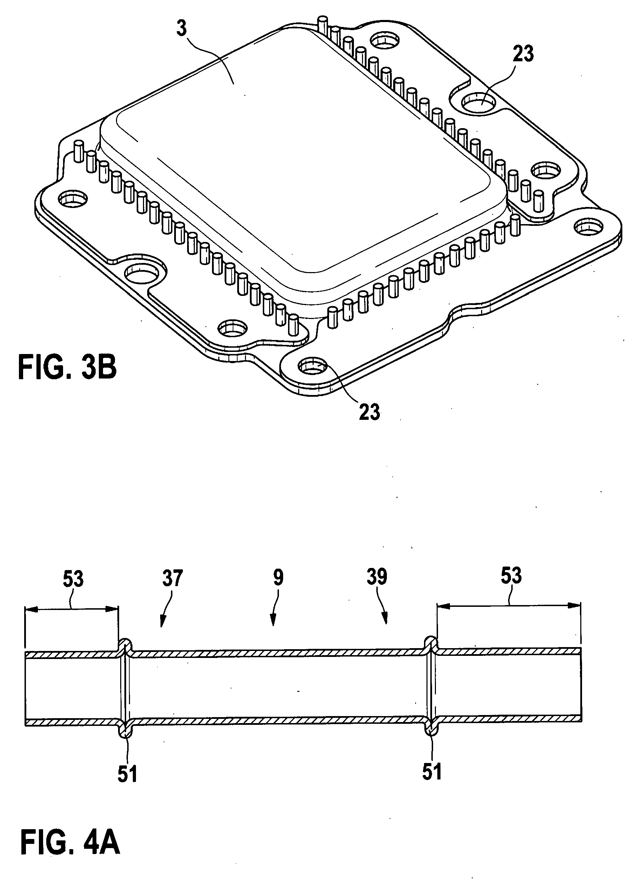

Das Steuergerät 3 weist elektronische Schaltungen und ein Schutzgehäuse auf, welches die Schaltungen beispielsweise vor dem im Getriebeinnenraum befindlichen Getriebeöl schützen kann. In Fig. 1 und 2 ist das Schutzgehäuse als Kunststoffummoldung ausgeführt. Diese Ausführungsform des Steuergeräts 3 wird auf der Oberseite der Leiterplatte 5 auf Lötpads gelötet. Eine alternative Ausführung des Steuergeräts 3 mit einem Metallgehäuse um die elektronischen Schaltungen ist in Fig. 3 dargestellt. Fig. 3A zeigt eine Oberseite und Fig. 3B eine Unterseite der alternativen Ausführungsform des Steuergeräts 3. Auf der Unterseite in Fig. 3B sind Pins sichtbar, die durch Lötaugen gesteckt und auf der Leiterplatte 5 festgelötet werden können.

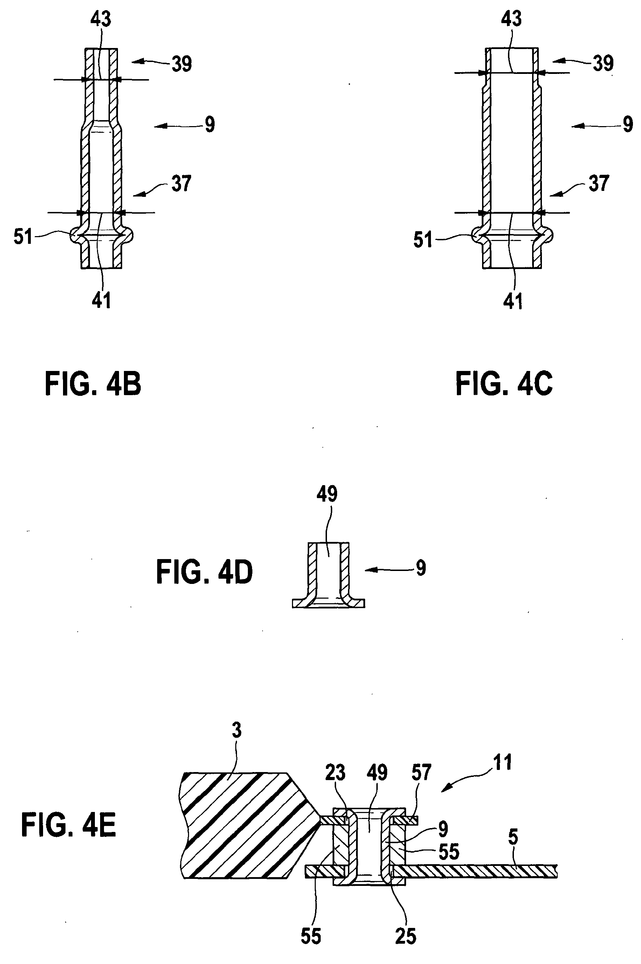

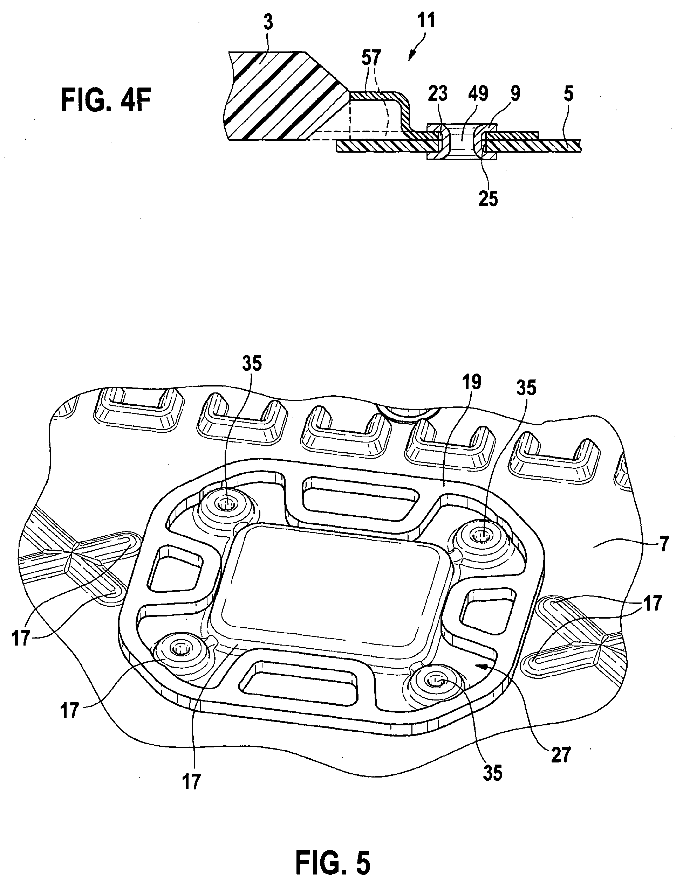

In Fig. 4 sind Querschnitte von unterschiedlichen Ausführungsformen der Hohlniete 9 dargestellt. Die Hohlniete 9 können zum Beispiel, wie in Fig. 1 und 2 dargestellt, als Drehteile mit einem Drehverfahren hergestellt werden. Alternativ können die Hohlniete 9 als Rohrniete, wie zum Beispiel in Fig. 4 dargestellt, ausgeführt werden. Fig. 4A zeigt beispielsweise einen Rohrniet 9 mit gleichbleibendem Innen- und Außendurchmesser und einem Doppelbund. Die Nietköpfe 53 können dabei unterschiedliche Längen aufweisen. Wie in Fig. 4B und C dargestellt, können die Niete 9 als Rohrniete mit jeweils einem Bund 51 und einem Durchmessersprung ausgeführt sein. Hierzu kann beispielsweise die Stärke bzw. Dicke der Nietwand variieren. Zusätzlich oder alternativ kann der Innendurchmesser und/oder der Außendurchmesser des Niets in einem Teilbereich variieren. In Fig. 4B ist ein Hohlniet 9 dargestellt, der einen ersten Bereich 37 und einen zweiten Bereich 39 aufweist. Der Hohlniet 9 weist ferner einen ersten Durchmesser 41 im ersten Bereich 37 und einen zweiten Durchmesser 43 im zweiten Bereich 39 auf. Dabei ist in Fig. 4B sowohl der Innen- als auch der Außendurchmesser des Hohlniets 9 im zweiten Bereich 39 kleiner als im ersten Bereich 37. In Fig. 4C ist der Innendurchmesser des ersten Bereichs 37 gleich dem Innendurchmesser des zweiten Bereichs 39. Allerdings ist der Außendurchmesser des Hohlniets 9 im zweiten Bereich 39 kleiner als der Außendurchmesser des Hohlniets im ersten Bereich 37. Alternativ kann ein Rohrniet mit zwei Durchmessersprüngen, also drei Bereichen mit unterschiedlichen Durchmessern, ausgeführt sein. Dabei kann der Bereich mit dem größten Durchmesser in der Mitte des Hohlniets liegen.

Der Hohlniet 9 kann wie in Fig. 4D dargestellt ohne Absatz oder Abstufung ausgeführt sein. Fig. 4E und 4F zeigen unterschiedliche Befestigungsmöglichkeiten der Hohlniete 9 mit der Leiterplatte 5 und dem Steuergerät 3. Dabei ist in diesen Ausführungsbeispielen das Steuergerät 3 in einer Aussparung in der Leiterplatte 5 angeordnet. In Fig. 4E ist ein Hohlniet 9 mit einem zusätzlichen Distanzelement 55 vorgesehen. Dieses kann eine gewünschte Distanz zwischen Hohlniet 9 und Steuergerät 3 sicherstellen. Bei Verwendung eines Distanzelements am Hohlniet 9 kann auf einen Absatz bzw. Durchmessersprung verzichtet werden. Die Hohlniete 9 verlaufen, wie auch in Fig. 1 zu sehen, durch eine Befestigungslasche 57 des Steuergeräts 3, die die erste Ausnehmung 23 aufweist.

Fig. 4F zeigt die Befestigung des Hohlniets an einer weiteren Ausführungsform des Steuergeräts 3. Dabei ist die Befestigungslasche 57 des Steuergeräts 3 so abgebogen, dass z.B. kein Absatz des Niets 9 bzw. kein Distanzelement 55 am Hohlniet 9 nötig ist. Alternativ kann die Befestigungslasche 57 des Steuergeräts 3 bereits in der vorgesehenen Höhe angeordnet sein. Dies ist in Fig. 4F gestrichelt dargestellt.

In Fig. 5 ist eine Trägerplatte 7 dargestellt, an der ein Schutzelement 19 angeordnet ist. Das Schutzelement bietet beispielsweise Schutz vor im Getriebeöl vorkommenden Spänen. Die Trägerplatte 7 weist dabei Positionierelemente 17 für das Schutzelement 19 auf. Das Schutzelement 19 kann sich an den Positionierelementen 17 ausrichten. Die Positionierelemente 17 können weitere Funktionen wie z.B. eine Versteifung der Trägerplatte 7 haben. Ferner weist die Trägerplatte 7 Aufnahmeelemente 35 auf, in die in einem späteren Verfahrensschritt Befestigungselemente, wie zum Beispiel Schrauben 15, eingeführt werden können. Die Aufnahmeelemente 35 entsprechen in ihrer geometrischen Anordnung zum Beispiel den ersten und zweiten Ausnehmungen 23, 25 und der entsprechenden Anordnung der Hohlniete 9. Das Schutzelement 19 weist dritte Ausnehmungen 27 auf, durch die die Befestigungselemente 15 eingeführt werden können. Das Schutzelement 19 ist dabei beispielsweise aus einem Elastomermaterial oder aus einem Schaumstoffteil gefertigt.

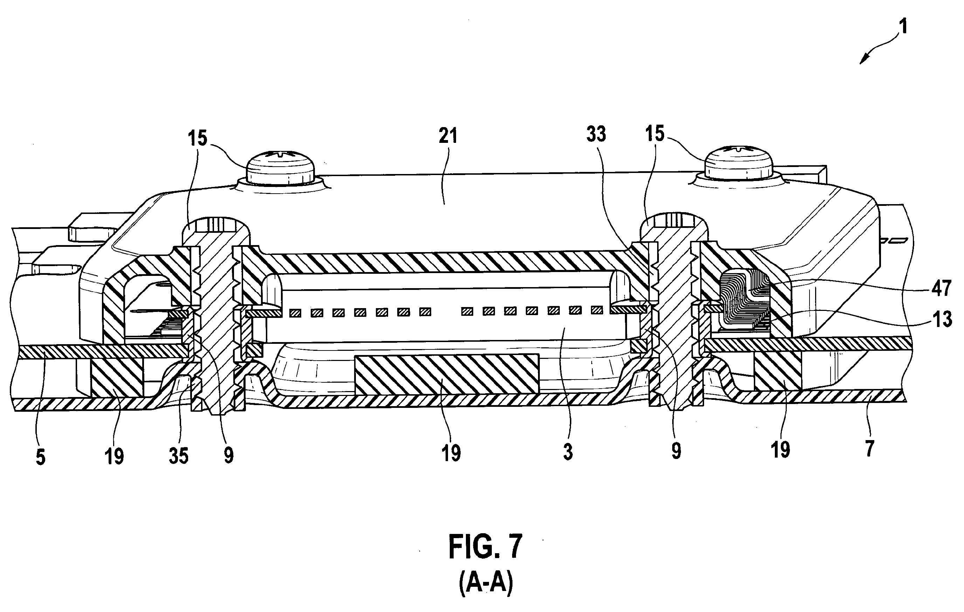

Die in Fig. 5 dargestellte Trägerplatte 7 weist eine angeformte Kühlfläche für das Steuergerät 3 auf. Hierfür kann die Leiterplatte, beispielsweise wie in Fig. 7 dargestellt, ausgespart sein. Alternativ kann das Steuergerät 3 einen tiefgezogenen Boden haben, der durch die Aussparung der Leiterplatte 5 hindurch ragt. Ferner kann die Leiterplatte 5 alternativ durchlaufend sein und das Steuergerät 3 nicht gekühlt werden.

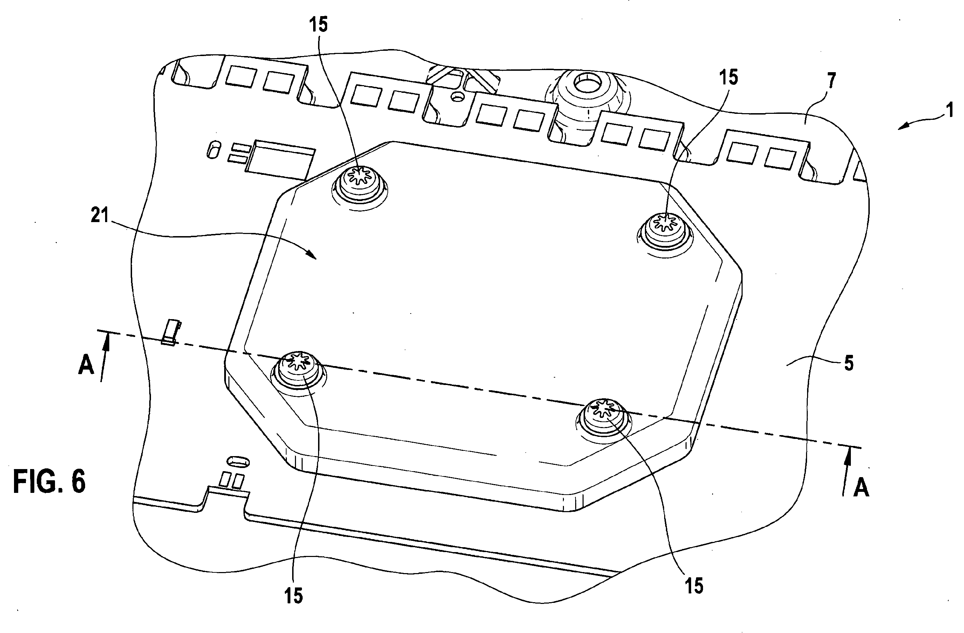

In Fig. 6 ist ein fertig zusammengebautes elektronisches Steuermodul 1 mit einem Gehäuseelement 21, das hier als Deckel ausgeführt ist, dargestellt. Wie in Fig. 7 gezeigt, werden die einzelnen Bauelemente des elektronischen Steuermoduls 1 mittels Befestigungselementen 15, die hier als Schrauben ausgeführt sind, zusammengehalten. Die einzelnen Elemente sind in einem Sandwich- bzw. Stapelaufbau angeordnet und mittels Schrauben in den Hohlräumen der Hohlniete platzsparend befestigt. Die einzelnen miteinander befestigten Elemente sind von unten nach oben wie folgt angeordnet: Trägerplatte 7, Schutzelement 19, erste Einheit 11 mit Steuergerät 3 und Leiterplatte 5.

Die Befestigungselemente 15 sind durch vierte Ausnehmungen 33 im Gehäuseelement 21 eingesetzt. Beispielsweise durch Verschrauben der Befestigungselemente 15 mit den Aufnahmeelementen 35 in der Trägerplatte 7 entsteht eine feste Verbindung der einzelnen Elemente des elektronischen Steuermoduls 1.

Ein Fertigungsverfahren eines elektronischen Steuermoduls 1 könnte beispielsweise wie folgt aussehen: Vernieten der Leiterplatte 5 auf einer Seite eines Hohlniets 9 und eines Steuergeräts 3 auf der anderen Seite des Hohlniets bzw. mehrerer Hohlnieten 9. Verlöten der elektrischen Anschlüsse 47 des Steuergeräts 3 mit der Leiterplatte 5. Anschließendes Einlegen des Spannschutzteils 19 in die Trägerplatte 7 und Aufsetzen der Leiterplatte 5 mit dem Steuergerät 3 und einem Deckel 21 auf die Trägerplatte 7 mit dem Schutzelement 19. Schließlich können alle Elemente mittels Befestigungselementen 15, die durch Hohlräume in den Hohlnieten 9 und Ausnehmungen in weiteren Bauelementen eingeführt werden, befestigt bzw. fixiert werden. Dabei greifen die Befestigungselemente wie in Fig. 7 dargestellt mit Aufnahmeelementen 35 in der Trägerplatte 7 ein.

Abschließend wird angemerkt, dass Ausdrücke wie "aufweisend" oder ähnliche nicht ausschließen sollen, dass weitere Elemente oder Schritte vorgesehen sein können. Des Weiteren sei darauf hingewiesen, dass "eine" oder "ein" keine Vielzahl ausschließen. Außerdem können in Verbindung mit den verschiedenen Ausführungsformen beschriebene Merkmale beliebig miteinander kombiniert werden. Es wird ferner angemerkt, dass die Bezugszeichen in den Ansprüchen nicht als den Umfang der Ansprüche beschränkend ausgelegt werden sollen.

## Patentansprüche

1. Elektronisches Steuermodul (1) zur Getriebesteuerung, das Steuermodul aufweisend
ein Steuergerät (3) zum Steuern des Getriebes;
eine Leiterplatte (5), mit der das Steuergerät (3) elektrisch verbunden ist; und
eine Trägerplatte (7);
**dadurch gekennzeichnet, dass**
die Leiterplatte mit dem Steuergerät (3) mittels Hohlnieten (9) zu einer ersten Einheit (11) verbunden ist; und
die erste Einheit (11) mittels Befestigungselementen (15) an der Trägerplatte (7) befestigt ist;
wobei die Befestigungselemente (15) in Hohlräumen (49) in den Hohlnieten (9) angeordnet sind.

2. Elektronisches Steuermodul (1) gemäß Anspruch 1,
ferner aufweisend ein Schutzelement (19);
wobei das Schutzelement (19) undurchlässig für Späne ausgeführt ist;
wobei das Schutzelement (19) zwischen der Trägerplatte (7) und der ersten Einheit (11) angeordnet ist.

3. Elektronisches Steuermodul (1) gemäß einem der Ansprüche 1 und 2, ferner aufweisend ein Gehäuseelement (21);
wobei das Gehäuseelement (21) auf einer der Trägerplatte (7) gegenüberliegenden Seite der ersten Einheit (11) angeordnet ist;
wobei das Gehäuseelement (21) mittels der Befestigungselemente (15) an der Trägerplatte (7) befestigt ist.

4. Elektronisches Steuermodul (1) gemäß einem der Ansprüche 1 bis 3,
wobei das Steuergerät (3) erste Ausnehmungen (23) aufweist;
wobei die Leiterplatte (5) zweite Ausnehmungen (25) aufweist;
wobei Abmessungen der ersten Ausnehmungen (23) und Abmessungen der zweiten Ausnehmungen (25) einer Außen-Abmessung der Hohlniete (9) entsprechen.

5. Elektronisches Steuermodul (1) gemäß einem der Ansprüche 1 bis 4,
wobei die Trägerplatte (7) Aufnahmeelemente (35) aufweist;
wobei die Befestigungselemente (15) mit den Aufnahmeelementen (35) eingreifen.

6. Elektronisches Steuermodul (1) gemäß einem der Ansprüche 1 bis 5,
wobei die Befestigungselemente (15) als Schrauben ausgeführt sind.

7. Elektronisches Steuermodul (1) gemäß einem der Ansprüche 1 bis 6,
wobei die Hohlniete (9) einen ersten Bereich (37) mit einem ersten Durchmesser (41) aufweisen;
wobei die Hohlniete (9) einen zweiten Bereich (39) mit einem zweiten Durchmesser (43) aufweisen;
wobei der erste Durchmesser (41) größer als der zweite Durchmesser (43) ist.

8. Verfahren zur Herstellung eines elektronischen Steuermoduls (1), das Verfahren aufweisend die folgenden Schritte
Bereitstellen eines Steuergeräts (3) mit ersten Ausnehmungen (23) und einer Leiterplatte (5) mit zweiten Ausnehmungen (25);
**dadurch gekennzeichnet, dass** das Verfahren die folgenden weiteren Schritte aufweist
Verbinden der Leiterplatte (5) mit dem Steuergerät (3) zu einer ersten Einheit (11) mittels Hohlnieten (9), die in den ersten und zweiten Ausnehmungen angeordnet sind;
Befestigen der ersten Einheit (11) an einer Trägerplatte (7) mittels Befestigungselementen (15), die in Hohlräumen (49) in den Hohlnieten (9) angeordnet sind.

9. Verfahren gemäß Anspruch 8, ferner aufweisend
Anordnen eines Schutzelements (19) zwischen der Trägerplatte (7) und der ersten Einheit (11);
wobei das Schutzelement (19) undurchlässig für Späne ausgeführt ist.

10. Verfahren gemäß einem der Ansprüche 8 und 9, ferner aufweisend Anordnen eines Gehäuseelements (21) an einer der Trägerplatte (7) gegenüberliegenden Seite der ersten Einheit (11);
wobei das Gehäuseelement (21) mittels der Befestigungselemente (15) an der Trägerplatte (7) befestigt ist.

## Claims

1. Electronic control module (1) for transmission control, the control module having
a control device (3) for controlling the transmission;
a printed circuit board (5) to which the control device (3) is electrically connected; and
a carrier plate (7);
**characterized in that**
the printed circuit board is connected to the control device (3) by means of hollow rivets (9) to form a first unit (11); and
the first unit (11) is fastened to the carrier plate (7) by means of fastening elements (15);
wherein the fastening elements (15) are arranged in hollow spaces (49) in the hollow rivets (9).

2. Electronic control module (1) according to Claim 1,
further having a protection element (19);
wherein the protection element (19) is designed to be impervious to swarf;
wherein the protection element (19) is arranged between the carrier plate (7) and the first unit (11).

3. Electronic control module (1) according to either of Claims 1 and 2,
further having a housing element (21);
wherein the housing element (21) is arranged on a side of the first unit (11) which is opposite the carrier plate (7);
wherein the housing element (21) is fastened to the carrier plate (7) by means of the fastening elements (15).

4. Electronic control module (1) according to one of Claims 1 to 3,
wherein the control device (3) has first recesses (23); wherein the printed circuit board (5) has second recesses (25);
wherein dimensions of the first recesses (23) and dimensions of the second recesses (25) correspond to an outside dimension of the hollow rivets (9).

5. Electronic control module (1) according to one of Claims 1 to 4,
wherein the carrier plate (7) has receiving elements (35);
wherein the fastening elements (15) engage with the receiving elements (35).

6. Electronic control module (1) according to one of Claims 1 to 5,
wherein the fastening elements (15) are designed as screws.

7. Electronic control module (1) according to one of Claims 1 to 6,
wherein the hollow rivets (9) have a first region (37) with a first diameter (41);
wherein the hollow rivets (9) have a second region (39) with a second diameter (43);
wherein the first diameter (41) is larger than the second diameter (43).

8. Method for producing an electronic control module (1), which method comprises the following steps providing a control device (3) having first recesses (23) and a printed circuit board (5) having second recesses (25);
**characterized in that** the method comprises the following further steps
connecting the printed circuit board (5) to the control device (3) to form a first unit (11) by means of hollow rivets (9) which are arranged in the first and second recesses;
fastening the first unit (11) to a carrier plate (7) by means of fastening elements (15) which are arranged in hollow spaces (49) in the hollow rivets (9).

9. Method according to Claim 8, further comprising arranging a protection element (19) between the carrier plate (7) and the first unit (11);
wherein the protection element (19) is designed to be impervious to swarf.

10. Method according to either of Claims 8 and 9, further comprising
arranging a housing element (21) on a side of the first unit (11) which is opposite the carrier plate (7); wherein the housing element (21) is fastened to the carrier plate (7) by means of the fastening elements (15).

## Revendications

1. Module de commande électronique (1) destiné à la commande d'engrenage, le module de commande possédant
un contrôleur (3) destiné à commander l'engrenage ;
un circuit imprimé (5) auquel est relié électriquement le contrôleur (3) ;
et
une plaque porteuse (7) ;
**caractérisé en ce que**
le circuit imprimé est relié au contrôleur (3) au moyen de rivets creux (9) pour former une première unité (11) ; et
la première unité (11) est fixée à la plaque porteuse (7) au moyen d'éléments de fixation (15) ;
les éléments de fixation (15) étant disposés dans des espaces creux (49) dans les rivets creux (9).

2. Module de commande électronique (1) selon la revendication 1,
possédant en outre un élément de protection (19) ; l'élément de protection (19) étant réalisé imperméable aux copeaux ;
l'élément de protection (19) étant disposé entre la plaque porteuse (7) et la première unité (11).

3. Module de commande électronique (1) selon l'une des revendications 1 et 2, possédant en outre un élément de boîtier (21) ;
l'élément de boîtier (21) étant disposé sur un côté de la première unité (11) à l'opposé de la plaque porteuse (7) ;
l'élément de boîtier (21) étant fixé à la plaque porteuse (7) au moyen des éléments de fixation (15).

4. Module de commande électronique (1) selon l'une des revendications 1 à 3,
le contrôleur (3) possédant des premières cavités (23) ;
le circuit imprimé (5) possédant des deuxièmes cavités (25) ;
les dimensions des premières cavités (23) et les dimensions des deuxièmes cavités (25) correspondant à une dimension externe des rivets creux (9).

5. Module de commande électronique (1) selon l'une des revendications 1 à 4,
la plaque porteuse (7) possédant des éléments d'accueil (35) ;
les éléments de fixation (15) venant en prise avec les éléments d'accueil (35).

6. Module de commande électronique (1) selon l'une des revendications 1 à 5,
les éléments de fixation (15) étant réalisés sous la forme de vis.

7. Module de commande électronique (1) selon l'une des revendications 1 à 6,
les rivets creux (9) possédant une première zone (37) ayant un premier diamètre (41) ;
les rivets creux (9) possédant une deuxième zone (39) ayant un deuxième diamètre (43) ;
le premier diamètre (41) étant supérieur au deuxième diamètre (43).

8. Procédé de fabrication d'un module de commande électronique (1), le procédé comprenant les étapes suivantes :
fourniture d'un contrôleur (3) comprenant des premières cavités (23) et d'un circuit imprimé (5) comprenant des deuxièmes cavités (25) ;
**caractérisé en ce que** le procédé comprend les étapes suivantes :
assemblage du circuit imprimé (5) avec le contrôleur (3) pour former une première unité (11) au moyen de rivets creux (9) qui sont disposés dans les premières et les deuxièmes cavités ;
fixation de la première unité (11) à une plaque porteuse (7) au moyen d'éléments de fixation (15) qui sont disposés dans des espaces creux (49) dans les rivets creux (9).

9. Procédé selon la revendication 8, comprenant en outre
disposition d'un élément de protection (19) entre la plaque porteuse (7) et la première unité (11) ; l'élément de protection (19) étant réalisé imperméable aux copeaux.

10. Procédé selon l'une des revendications 8 et 9, comprenant en outre
montage d'un élément de boîtier (21) sur un côté de la première unité (11) à l'opposé de la plaque porteuse (7) ;
l'élément de boîtier (21) étant fixé à la plaque porteuse (7) au moyen des éléments de fixation (15).
